# EUROPÄISCHE PATENTSCHRIFT

(11) **EP 2 553 703 B1**
(45) Veröffentlichungstag und Bekanntmachung des Hinweises auf die Patenterteilung: **28.01.2015**
(21) Anmeldenummer: 11714248.9
(22) Anmeldetag: 31.03.2011
(51) Int. Cl.: H01H 37/42, H01H 37/46, G01K 5/00, H01H 37/36, H05K 1/02

(54) **SYSTEM ZUR THERMISCHEN SICHERUNG EINER ELEKTRISCHEN VORRICHTUNG**
THERMAL FUSE SYSTEM FOR AN ELECTRICAL DEVICE
SYSTÈME DE PROTECTION THERMIQUE D'UN DISPOSITIF ÉLECTRIQUE

(30) Priorität: 31.03.2010 DE 102010013767
(43) Veröffentlichungstag der Anmeldung: 06.02.2013
(73) Patentinhaber: Phoenix Contact GmbH & Co. KG, 32825 Blomberg (DE)
(72) Erfinder: DURTH, Rainer, 32805 Horn-Bad Meinberg (DE); DEPPING, Christian, 32657 Lemgo (DE); MEYER, Thomas, 31868 Ottenstein (DE)
(74) Vertreter: Michalski Hüttermann & Partner Patentanwälte mbB
(86) Internationale Anmeldenummer: PCT/EP2011/055022
(87) Internationale Veröffentlichungsnummer: WO 2011/121080

(56) Entgegenhaltungen:
- EP-A2- 1 577 918
- DE-A1- 2 354 205
- US-A1- 2008 098 803

## Beschreibung

Die Erfindung betrifft ein System zur thermischen Sicherung einer elektrischen Vorrichtung mit mehreren zu überwachenden Bauteilen bzw. Überwachungspunkten.

Überwachung und Schutz von elektrischen Vorrichtungen wie Schaltkreisen etc. gegen Überhitzung ist eine lang bekannte Aufgabenstellung und resultiert daraus, dass es bei Überlastung und elektrischer Alterung von elektronischen Bauteilen zu deren Schädigung bzw. Zerstörung aufgrund von Kurzschlüssen, Lichtbögen etc. kommen kann.

Eine thermische Überwachung wird jedoch gerade dann besonders aufwendig bzw. unmöglich, wenn - wie bei Leiterplatten - mehrere Bauteile auf begrenztem Bauraum angebracht sind. Bei solchen Anordnungen wird daher in der Technik meist eine Lösung gewählt, die jedes einzelne Bauteil eigens überwacht, was Überwachungssystem aufwändig und platzintensiv macht. Zudem ist es dann meist unmöglich, die Signalisierung einer Überhitzung bzw. Überlastung, z.B. eine Anzeige am Gerät oder ein fernabfragbares System, zu erreichen.

Aus der EP 1 577 918 A2 ist eine Überwachungsvorrichtung zur Erfassung von lokal auftretenden Übertemperaturen, mit einer aus einer elektrischen Reihenschaltung von mehreren Bimetallschaltern bestehenden Schalteranordnung bekannt. Die Bimetallschalter sind unterhalb einer wählbar vorgebbaren, bauartbedingten Schalttemperatur geschlossen und schalten bei Überschreitung der Schalttemperatur in den geöffneten Zustand um. Die Bimetallschalter können in linearer, flächenhafter oder auch räumlicher Form angeordnet sein und sind in ihrer gegenseitigen Lage zueinander im Wesentlichen fixiert. Die Bimetallschalter weisen ein irreversibles Schaltverhalten auf.

Der Erfindung liegt die Aufgabe zu Grunde, ein System zur Sicherung einer elektrischen Vorrichtung zu schaffen, bei dem auf einfache Weise eine Überwachung bzw. Schutz von Bauteilen oder wichtigen Überwachungspunkten vor Überhitzung erzielt werden kann.

Die Lösung der Aufgabe erfolgt erfindungsgemäß durch die Merkmale des Gegenstands des Patentanspruchs 1. Vorteilhafte Ausgestaltungen der Erfindung sind in den Unteransprüchen angegeben.

Demgemäß ist eine Elektrische Vorrichtung mit einem System zur thermischen Sicherung mehrerer zu überwachender Bauteile und/oder Überwachungspunkte angegeben, wobei das System mindestens ein thermosensitives Element sowie mindestens einen Aktor umfasst, wobei jedem thermosensitiven Element ein Aktor zugeordnet ist, und das thermosensitive Element in einer Hülle bzw. Röhre, die im Wesentlichen thermisch formstabil ist, angeordnet ist, flexibel auf der zu überwachenden elektrischen Vorrichtung angeordnet ist, wobei jedes thermosensitive Element mit einer Mehrzahl zu überwachender Bauteile bzw. Überwachungspunkte thermisch verkoppelt ist, das thermosensitive Element derart ausgestaltet ist, dass es bei Überhitzung eines Bauteils oder Überwachungspunktes oberhalb einer Schwelltemperatur eine Längen- oder Volumenänderung durchläuft, und das thermosensitive Element derart mit dem Aktor verbunden ist, dass der Aktor in Abhängigkeit von der Längen- oder Volumenänderung des thermosensitiven Elements eine Aktion auslöst.

Der Begriff "elektrische Vorrichtung" umfasst dabei insbesondere elektrische Schaltkreise, Leiterplatten etc..

Der Begriff "Überwachungspunkte" soll im Sinne der vorliegenden Erfindung insbesondere dergestalt verstanden werden, dass bestimmte Orte in oder bei der elektrischen Vorrichtung (auch wenn dort kein Bauteil vorgesehen ist) thermisch überwacht werden sollen. Beispielsweise soll eine unzulässige Erwärmung von Leitern bzw. Leiterbahnen aufgrund einer Überlastung durch einen zu hohen Strom erkannt werden.

Der Begriff "thermosensitives Element" umfasst im Sinne der vorliegenden Erfindung insbesondere ein Material, welches oberhalb einer Schwelltemperatur eine Längen- oder Volumenänderung durchläuft, wobei die Schwelltemperatur die Temperatur ist, oberhalb derer die Bauteile und/oder die elektrische Vorrichtung vor Überhitzung geschützt oder bewahrt werden sollen.

Der Begriff "Aktor" soll im Sinne der vorliegenden Erfindung weitumfassend verstanden werden und umfasst z.B. Vorrichtungen, die ein Signal auslösen, welches mechanisch und/oder elektrisch sein kann, Vorrichtungen, die die Stromversorgung der elektrischen Vorrichtung und/oder einzelner Bauteile innerhalb derselben unterbrechen oder trennen.

Ein solches System hat bei vielen Ausführungsformen der Erfindung mindestens einen oder mehrere der folgenden Vorteile:
Durch das thermosensitive Element ist es möglich, gleichzeitig mehrere Bauteile, vorzugsweise alle Bauteile auf der elektrischen Vorrichtung gleichzeitig zu überwachen; dies ist zum einen platzsparend, zum anderen effizient. Das thermosensitive Element ist so funktional, dass seine Funktion auch ohne elektrische Energie sichergestellt ist, so dass die Zuverlässigkeit des Systems verbessert wird. Durch das thermosensitive Element zusammen mit dem dazugehörigen Aktor ist eine Signalisierung einer Störung möglich.

Gemäß einer bevorzugten Ausführungsform der Erfindung ist das thermosensitive Element innerhalb einer Röhre angeordnet, welche thermisch im Wesentlichen formstabil ist. Der Begriff "Röhre" ist dabei weit umfassend zu verstehen und kann auch Ausführungsformen umfassen, die ansonsten auch als "Hülle" bzw. "Leitung" oder "Kapillare" bezeichnet würden.

Wird eine solche Ausführungsform gewählt, so entsteht, wenn das thermosensitive Element entsprechend ausgebildet ist, eine Art Bowdenzug, so dass die Kraftübertragung auf den Aktor verbessert wird und insbesondere das thermosensitive Element bzw. die Röhre nicht linear sein muss, sondern fast beliebig auf bzw. bei der elektrischen Vorrichtung angeordnet sein kann.

Gemäß einer bevorzugten Ausführungsform der Erfindung durchläuft das Material des thermosensitiven Elements bei der Längen- oder Volumenänderung einen Phasenübergang. Eine derartige Ausführungsform hat den Vorteil, dass die Längenoder Volumenveränderung dann meist schlagartig erfolgt statt graduell, d.h. die Auslösung des Aktors erfolgt noch zuverlässiger.

Gemäß einer bevorzugten Ausführungsform der Erfindung durchläuft das Material des thermosensitiven Elements bei der Längen- oder Volumenänderung eine Kontraktion. Dazu wird bevorzugt das Material des thermosensitiven Elements derart gewählt, dass es ein Thermoplast enthält, welches z.B. nach Art der Materialien, die bei Schrumpfschläuchen verwendet werden nach dem Extrudieren vernetzt wurde. Geeignete Thermoplaste umfassen Polyolefine, PVC oder fluorhaltige Polymere wie Polyvinylidenfluorid, Teflon, Fluorkautschuke etc.. Ebenfalls bevorzugte Materialien sind Formgedächtnispolymere. Bevorzugt wird ein Material gewählt, welches sich oberhalb der Schwelltemperatur um einen Faktor 2 bis 5 zusammenzieht; derartige Materialien sind z.B. die unter dem Markennamen Viton vertriebene Fluorelastomere der Fa. Dupont. Das thermosensitive Element kann auch ein Formgedächtnismetall enthalten.

Gemäß einer bevorzugten alternativen Ausführungsform der Erfindung durchläuft das Material des thermosensitiven Elements bei der Längen- oder Volumenänderung eine Ausdehnung. Auch hier ist der Einsatz von Thermoplasten, Formgedächtnispolymeren und/oder Formgedächtnismetallen besonders bevorzugt.

Gemäß einer bevorzugten Ausführungsform der Erfindung ist das thermosensitive Element als Flüssigkeit oder viskoses Material innerhalb der als Kapillare ausgebildeten Röhre vorgesehen.

Bei dieser Ausführungsform ist es besonders vorteilhaft, wenn das thermosensitive Element ein viskoses Material wie Öl, Wachs, Paraffin oder geeignete Metalle bzw. Legierungen, wie Blei und/oder Zinn, enthält.

Bevorzugt ist bei dieser Ausführungsform die Kapillare an einer Seite geschlossen, und an der anderen Seite ist der Aktor angeordnet. Dieser kann z.B. ein beweglicher Kolben oder eine Membran sein. Die Längen- oder Volumenänderung des thermosensitiven Elements wirkt dann direkt auf den Aktor, welcher dann z.B. ein Signal oder eine Unterbrechung bewirkt.

Gemäß einer bevorzugten Ausführungsform der Erfindung ist die Längen- oder Volumenänderung des thermosensitiven Elements reversibel.

Die vorgenannten sowie die beanspruchten und in den Ausführungsbeispielen beschriebenen erfindungsgemäß zu verwendenden Bauteile unterliegen in ihrer Größe, Formgestaltung, Materialauswahl und technischen Konzeption keinen besonderen Ausnahmebedingungen, so dass die in dem Anwendungsgebiet bekannten Auswahlkriterien uneingeschränkt Anwendung finden können.

Weitere Einzelheiten, Merkmale und Vorteile des Gegenstandes der Erfindung ergeben sich aus den Unteransprüchen sowie aus der nachfolgenden Beschreibung der zugehörigen Zeichnungen, in denen - exemplarisch - mehrere Ausführungsbeispiele des erfindungsgemäßen Systems dargestellt sind. In der Zeichnung zeigt
- Fig. 1: eine schematische Darstellung eines Systems gemäß einer ersten Ausführungsform der Erfindung; und
- Fig. 2: eine schematische Darstellung eines Systems gemäß einer zweiten Ausführungsform der Erfindung.

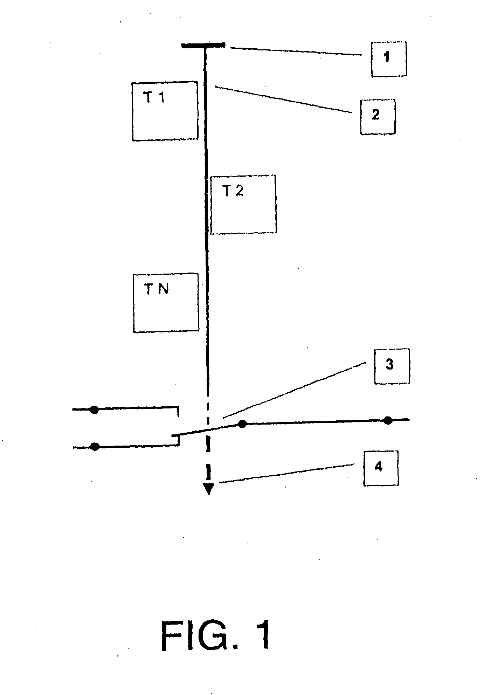

Figur 1 zeigt eine schematische Darstellung eines Systems gemäß einer ersten Ausführungsform der Erfindung. Gemäß Figur 1 ist ein thermosensitives Element 2 in Form einer Thermoschnur vorgesehen, welches an einem Ende an einem Festlager 1 befestigt ist. Das thermosensitive Element 2 läuft so an den verschiedenen thermisch zu überwachenden Bauteilen T1, T2 bis TN entlang, dass es mit diesen thermisch verkoppelt ist. An dem anderen Ende des thermosensitiven Elements befindet sich der zugehörige Aktor 3 in Form eines Schalters. Das thermosensitive Element 2 umfasst ein Material, welches sich ab der Schwelltemperatur zusammenzieht und dadurch den Aktor 3 auslösen kann. Dieser kann nun entweder ein Signal aussenden, angedeutet durch den Pfeil 4, oder z.B. einzelne oder alle Bauteile abschalten oder trennen.

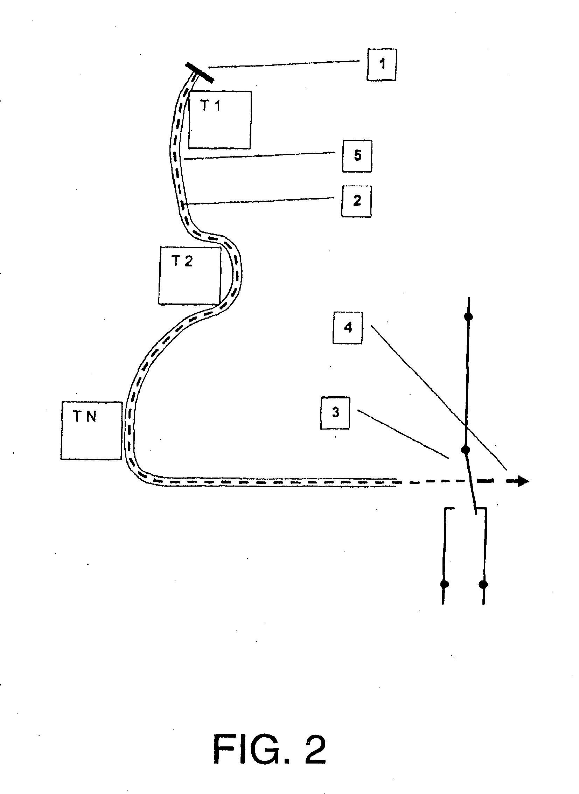

Figur 2 zeigt eine weitere schematische Darstellung eines Systems gemäß einer zweiten Ausführungsform der Erfindung. Diese unterscheidet sich von der Ausführungsform gemäß Fig. 1 dadurch, dass das thermosensitive Element 2 in einer Hülle bzw. Röhre 5 angeordnet ist, die im Wesentlichen formstabil ist, d.h. sich bei Erhitzen nicht ausdehnt oder komprimiert. Dadurch wird eine Kraftübertragung analog zu einem Bowdenzug erreicht. Durch diese Anordnung kann das thermosensitive Element 2 bzw. die Röhre 5 auch flexibel, z.B. schlangenförmig, auf der zu überwachenden elektrischen Vorrichtung angeordnet sein, wie in Fig. 2 dargestellt ist.

Alternativ ist es natürlich auch möglich, das thermosensitive Element 2 abschnittsweise über Rollen etc. zu führen, wenn in diesem Abschnitt keine Überwachung notwendig ist. Das thermosensitive Element 2 soll vorliegend aber derart angeordnet werden, dass bei Überhitzung eines Bauteils ein Zug auf den Aktor 3 entsteht.

Gemäß einer weiteren in der Zeichnung nicht gezeigten Ausführungsform ist die Röhre bzw. Hülle als Kapillare ausgebildet. In Analogie zu Fig. 2 ist diese Röhre 5 dann auf einer Seite geschlossen. Das thermosensitive Element 2 ist dann entweder eine Flüssigkeit oder ein viskoses Material wie Wachs oder ein Metall (Blei/Zinn), welches sich beim Erwärmen ausdehnt und so den Aktor 3 betätigt.

Die einzelnen Kombinationen der Bestandteile und der Merkmale von den bereits erwähnten Ausführungen sind exemplarisch; der Austausch und die Substitution dieser Lehren mit anderen Lehren, die in dieser Druckschrift enthalten sind mit den zitierten Druckschriften werden ebenfalls ausdrücklich erwogen. Der Fachmann erkennt, dass Variationen, Modifikationen und andere Ausführungen, die hier beschrieben werden, ebenfalls auftreten können ohne von dem Erfindungsgedanken und dem Umfang der Erfindung abzuweichen.

Entsprechend ist die obengenannte Beschreibung exemplarisch und nicht als beschränkend anzusehen. Das in den Ansprüchen verwendete Wort "umfassen" schließt nicht andere Bestandteile oder Schritte aus. Der unbestimmte Artikel "ein" schließt nicht die Bedeutung eines Plurals aus. Die bloße Tatsache, dass bestimmte Maße in gegenseitig verschiedenen Ansprüchen rezitiert werden, verdeutlicht nicht, dass eine Kombination von diesen Maßen nicht zum Vorteil benutzt werden kann.

### Bezugszeichenliste

- Festlager: 1
- thermosensitives Element: 2
- Aktor: 3
- Signalübertragung: 4
- Röhre: 5
- zu überwachende Bauteile: T1,T2,TN

## Patentansprüche

1. Elektrische Vorrichtung mit einem System zur thermischen Sicherung mehrerer zu überwachender Bauteile und/oder Überwachungspunkte (T1, T2, TN), wobei
das System mindestens ein thermosensitives Element (2) sowie mindestens einen Aktor (3) umfasst, wobei jedem thermosensitiven Element (2) ein Aktor (3) zugeordnet ist, und
das thermosensitive Element (2) in einer Hülle bzw. Röhre (5), die im Wesentlichen thermisch formstabil ist, flexibel auf der zu überwachenden elektrischen Vorrichtung angeordnet ist,
**dadurch gekennzeichnet, dass**
jedes thermosensitive Element (2) mit einer Mehrzahl zu überwachender Bauteile bzw. Überwachungspunkte (T1, T2, TN) thermisch verkoppelt ist,
das thermosensitive Element (2) derart ausgestaltet ist, dass es bei Überhitzung eines Bauteils oder Überwachungspunktes (T1, T2, TN) oberhalb einer Schwelltemperatur eine Längen- oder Volumenänderung durchläuft, und
das thermosensitive Element (2) derart mit dem Aktor (3) verbunden ist, dass der Aktor (3) in Abhängigkeit von der Längen- oder Volumenänderung des thermosensitiven Elements (2) eine Aktion auslöst.

2. Elektrische Vorrichtung nach Anspruch 1, wobei die Aktion, die der Aktor (3) in Abhängigkeit von der Längenoder Volumenänderung des thermosensitiven Elements (2) auslöst ein Signal ist.

3. Elektrische Vorrichtung nach Anspruch 1, wobei die Aktion, die der Aktor (3) in Abhängigkeit von der Längen-oder Volumenänderung des thermosensitiven Elements (2) auslöst eine Trennung der Bauteile und/oder Überwachungspunkte (T1, T2, TN) von einer Stromversorgung ist.

4. Elektrische Vorrichtung nach einem der Ansprüche 1 bis 3, wobei das Material des thermosensitiven Elements (2) bei der Längen- oder Volumenänderung einen Phasenübergang durchläuft.

5. Elektrische Vorrichtung nach einem der Ansprüche 1 bis 4, wobei das Material des thermosensitiven Elements (2) bei der Längen- oder Volumenänderung eine Kontraktion durchläuft.

6. Elektrische Vorrichtung nach einem der Ansprüche 1 bis 4, wobei das Material des thermosensitiven Elements (2) bei der Längen- oder Volumenänderung eine Ausdehnung durchläuft.

7. Elektrische Vorrichtung nach einem der Ansprüche 4 bis 6, wobei das thermosensitive Element (2) als Flüssigkeit oder viskoses Material innerhalb der als Kapillare ausgebildeten Röhre (5) vorgesehen ist.

8. Elektrische Vorrichtung nach einem der Ansprüche 1 bis 7, wobei die Längen- oder Volumenänderung des thermosensitiven Elements (2) reversibel ist.

## Claims

1. Electric device with a system for thermal safeguarding of several monitored components and/or monitoring points (T1, T2, TN), wherein
the system comprises at least one thermosensitive element (2) and at least one actuator (3), whereby an actuator (3) is assigned to each thermosensitive element (2) is , and
the thermosensitive element (2) is flexibly arranged on the electric device being monitored in a sleeve or tube (5) that is basically thermally shape-stable,
**characterized in, that**
each thermosensitive element (2) is thermally coupled to several of the monitored components or monitoring points (T1, T2, TN),
the thermosensitive element (2) is configured such that it undergoes a change in length or volume above a threshold temperature upon overheating of a component or monitoring point (T1, T2, TN), and
the thermosensitive element (2) is connected to the actuator (3) such that the actuator (3) triggers an action in dependence on the change in length or volume of the thermosensitive element (2).

2. Electric device according to claim 1, wherein the action which the actuator (3) triggers in dependence on the change in length or volume of the thermosensitive element (2) is a signal.

3. Electric device according to claim 1, wherein the action which the actuator (3) triggers in dependence on the change in length or volume of the thermosensitive element (2) is a separating of the components and/or monitoring points (T1, T2, TN) from a power supply.

4. Electric device according to one of the preceding claims, wherein the material of the thermosensitive element (2) undergoes a phase transition during the change in length or volume.

5. Electric device according to one of the preceding claims, wherein the material of the thermosensitive element (2) undergoes a contraction during the change in length or volume.

6. Electric device according to one of claims 1 to 4, wherein wherein the material of the thermosensitive element (2) undergoes an expansion during the change in length or volume.

7. Electric device according to one of claims 3 to 6, wherein the thermosensitive element (2) is provided as a liquid or viscous material inside the tube (5), fashioned as a capillary.

8. Electric device according to one of the preceding claims, wherein the change in length or volume of the thermosensitive element (2) is reversible.

## Revendications

1. Dispositif électrique avec un système pour la sécurité thermique de plusieurs composants à surveiller et/ou points de surveillance (T1, T2, TN), dans lequel
le système comprend au moins un élément thermosensible (2) ainsi qu'au moins un actionneur (3), un actionneur (3) étant attribué à chaque élément thermosensible (2), et
l'élément thermosensible (2) est agencé de manière souple sur le dispositif électrique à surveiller, dans une enveloppe ou une conduite (5) de forme essentiellement stable thermiquement,
**caractérisé en ce que**
chaque élément thermosensible (2) est accouplé thermiquement à une pluralité de composants à surveiller et/ou de points de surveillance (T1, T2, TN),
l'élément thermosensible (2) est conçu de manière à ce qu'en cas de surchauffe d'un composant ou d'un point de surveillance (T1, T2, TN) au-delà d'une température seuil, subit une modification de longueur ou de volume, et
l'élément thermosensible (2) est relié de telle façon avec l'actionneur (3), que l'actionneur (3) déclenche une action en fonction de la modification de longueur ou de volume de l'élément thermosensible (2).

2. Dispositif électrique selon la revendication 1, dans lequel l'action déclenchée par l'actionneur (3) en fonction de la modification de longueur ou de volume de l'élément thermosensible (2) est un signal.

3. Dispositif électrique selon la revendication 1, dans lequel l'action déclenchée par l'actionneur (3) en fonction de la modification de longueur ou de volume est une séparation des composants et/ou des points de surveillance (T1, T2, TN) par rapport à une alimentation électrique.

4. Dispositif électrique selon l'une des revendications 1 à 3, dans lequel le matériau de l'élément thermosensible (2) subit une transition de phase lors de la modification de longueur ou de volume.

5. Dispositif électrique selon l'une des revendications 1 à 4, dans lequel le matériau de l'élément thermosensible (2) subit une contraction lors de la modification de longueur ou de volume.

6. Dispositif électrique selon l'une des revendications 1 à 4, dans lequel le matériau de l'élément thermosensible (2) subit une dilatation lors de la modification de longueur ou de volume.

7. Dispositif électrique selon l'une des revendications 4 à 6, dans lequel l'élément thermosensible (2) est prévu sous la forme d'un matériau liquide ou visqueux à l'intérieur des conduites (5) conçues comme des capillaires.

8. Dispositif électrique selon l'une des revendications 1 à 7, dans lequel la modification de longueur ou de volume de l'élément thermosensible (2) est réversible.
